# EUROPEAN PATENT APPLICATION

(11) **EP 4 199 303 A1**
(43) Date of publication of application: **21.06.2023**
(21) Application number: 22842375.2
(22) Date of filing: 07.07.2022
(51) Int. Cl.: H02J 7/00, H02J 7/34, H01M 10/42

(54) **BATTERY DEVICE, BATTERY MANAGEMENT SYSTEM, AND DIAGNOSIS METHOD**

(30) Priority: 14.07.2021 KR 20210092482
(71) Applicant: LG Energy Solution, Ltd., Seoul 07335 (KR)
(72) Inventor: PARK, Hangon, Daejeon 34122 (KR); KIM, Kihoon, Daejeon 34122 (KR)
(74) Representative: Plasseraud IP
(86) International application number: PCT/KR2022/009880
(87) International publication number: WO 2023/287113

(57) **Abstract**

In a battery apparatus, a first switch is connected between a first terminal of a first battery pack and a first link terminal, a second switch is connected between a second terminal of the first battery pack and a second link terminal, a third switch is connected between a first terminal of a second battery pack and the first link terminal, and a fourth switch connected between a second terminal of the second battery pack and the second link terminal. A first diagnosis circuit a first capacitor for charging a voltage of the first battery pack when the first switch and the second switch are closed, and a second diagnosis circuit includes a second capacitor for charging a voltage of the second battery pack when the third switch and the fourth switch are closed. A processor diagnoses a first switching circuit based on the voltage of the first battery pack and a voltage of the first capacitor, and diagnoses a second switching circuit based on the voltage of the second battery pack and a voltage of the second capacitor.

## Description

### [Technical Field]

### CROSS-REFERENCE TO RELATED APPLICATION

This application claims priority to and the benefit of Korean Patent Application No. 10-2021-0092482 filed in the Korean Intellectual Property Office on July 14, 2021, the entire contents of which are incorporated herein by reference.

The technology described below relates to a battery apparatus, a battery management system, and a diagnosis method.

### [Background Art]

An electric vehicle is a vehicle that obtains power by driving a motor mainly using a battery as a power supply. The electric vehicles are being actively researched because they are alternatives that can solve pollution and energy problems of internal combustion vehicles. Rechargeable batteries are used in various external apparatuses other than the electric vehicles.

Recently, as a battery having a high output and a large capacity is required, a battery apparatus in which a plurality of battery packs are connected in parallel is used. A switching circuit for a connection control of the battery pack may be used for each battery pack. Since the battery packs are connected to the same external link terminal, it is not possible to diagnose a fault (e.g., stuck fault) of a switch (e.g., contactor) in the switching circuit for each battery pack.

### [Disclosure]

### [Technical Problem]

Some embodiments may provide a battery apparatus, a battery management system, and a diagnosis method for diagnosing a fault of a switching circuit in each battery pack.

### [Technical Solution]

According to an embodiment, a battery apparatus connected to an external apparatus through a first link terminal and a second link terminal may be provided. The battery apparatus may include a first battery pack and a second battery pack connected in parallel, a first switching circuit, a second switching circuit, a first diagnosis circuit, a second diagnosis circuit, and a processor. The first switching circuit may include a first switch connected between a first terminal of the first battery pack and the first link terminal, and a second switch connected between a second terminal of the first battery pack and the second link terminal. The second switching circuit may include a third switch connected between a first terminal of the second battery pack and the first link terminal, and a fourth switch connected between a second terminal of the second battery pack and the second link terminal. The first diagnosis circuit may include a first capacitor configured to charge a voltage of the first battery pack when the first switch and the second switch are closed, and the second diagnosis circuit may include a second capacitor configured to charge a voltage of the second battery pack when the third switch and the fourth switch are closed. The processor may diagnose the first switching circuit based on the voltage of the first battery pack and a voltage of the first capacitor, and diagnose the second switching circuit based on the voltage of the second battery pack and a voltage of the second capacitor.

In some embodiments, when a difference between the voltage of the first battery pack and the voltage of the first capacitor is less than or equal to a predetermined voltage, the processor may diagnose that the first switching circuit is normal.

In some embodiments, when a difference between the voltage of the first battery pack and the voltage of the first capacitor is greater than a predetermined voltage, the processor may diagnose that the first switching circuit is faulty.

In some embodiments, when a voltage of the first capacitor is greater than a predetermined ratio of the voltage of the first battery pack, the processor may diagnose that the first switching circuit is normal.

In some embodiments, when a voltage of the first capacitor is less than or equal to a predetermined ratio of the voltage of the first battery pack, the processor may diagnose that the first switching circuit is faulty.

In some embodiments, the first diagnosis circuit may further include a fifth switch and a sixth switch. The first switch may be connected between the first terminal of the first battery pack and a node, the fifth switch and the first capacitor may be connected in series between the node and the second link terminal, and the sixth switch may be connected between the node and the first link terminal.

In some embodiments, the processor may open the sixth switch and close the first switch, the second switch, and the fifth switch to charge the first capacitor, and close the sixth switch and open the fifth switch to supply the voltage of the first battery pack to the first link terminal.

In some embodiments, the first capacitor and the second capacitor may be provided separately from a capacitor used for precharge.

According to another embodiment, a battery management system of a battery apparatus having a first link terminal and a second link terminal connected to an external apparatus may be provided. The battery management system may include a switching circuit including a first switch and a second switch, a third switch, a capacitor, a fourth switch, and a processor. The first switch may be connected between a first terminal of a battery pack of the battery apparatus and a node, and the second switch may be connected between a second terminal of the battery pack and the second link terminal. The third switch and the capacitor may be connected in series between the node and the second link terminal, and the fourth switch may be connected between the node and the first link terminal. The processor may control the first switch, the second switch, the third switch, and the fourth switch.

In some embodiments, the processor may diagnose the switching circuit based on a voltage of the battery pack and a voltage of the capacitor.

In some embodiments, for diagnosis of the switching circuit, the processor may open the fourth switch and close the first switch, the second switch, and the third switch to charge the capacitor.

In some embodiments, the processor may close the fourth switch and open the third switch to supply the voltage of the battery pack to the external apparatus after diagnosing the switching circuit.

In some embodiments, when a difference between the voltage of the battery pack and the voltage of the capacitor is less than or equal to a predetermined voltage, the processor may diagnose that the switching circuit is normal.

In some embodiments, when a difference between the voltage of the battery pack and the voltage of the capacitor is greater than a predetermined voltage, the processor may diagnose that the switching circuit is faulty.

According to yet another embodiment, a diagnosis method of a battery apparatus including a plurality of battery packs connected in parallel may be provided. The diagnosis method may include charging a plurality of capacitors respectively provided in the plurality of battery packs, comparing a voltage of each of the plurality of battery packs with a voltage of a corresponding capacitor among a plurality of capacitors, when a difference between a voltage of a first battery pack among the plurality of battery packs and a voltage of a capacitor corresponding to the first battery pack among the plurality of capacitors is less than or equal to a predetermined voltage, diagnosing that a switching circuit connected to the first battery pack is normal; and when a difference between a voltage of a second battery pack among the plurality of battery packs and a voltage of a capacitor corresponding to the second battery pack among the plurality of capacitors is greater than the predetermined voltage, diagnosing that a switching circuit connected to the second battery pack is faulty.

### [Advantageous Effects]

According to some embodiments, when parallel battery packs are used, a switching circuit connected to each battery pack can be diagnosed individually.

### [Description of the Drawings]

FIG. 1 is a diagram showing an example of a battery apparatus according to an embodiment.
FIG. 2 is a drawing showing an example of a battery apparatus according to another embodiment.
FIG. 3 is a drawing showing an example of switching timings of a battery apparatus shown in FIG. 2.
FIG. 4 is a drawing showing an example of a battery apparatus according to yet another embodiment.
FIG. 5 is a drawing showing an example of switching timings of a battery apparatus shown in FIG. 4.
FIG. 6 is a flowchart showing an example of a diagnosis method according to an embodiment.

### [Mode for Invention]

In the following detailed description, only certain embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. Like reference numerals designate like elements throughout the specification.

When it is described that an element is "connected" to another element, it should be understood that the element may be directly connected to the other element or connected to the other element through a third element. On the other hand, when it is described that an element is "directly connected" to another element, it should be understood that the element is connected to the other element through no third element.

As used herein, a singular form may be intended to include a plural form as well, unless the explicit expression such as "one" or "single" is used.

In flowcharts described with reference to the drawings, the order of operations or steps may be changed, several operations or steps may be merged, a certain operation or step may be divided, and a specific operation or step may not be performed.

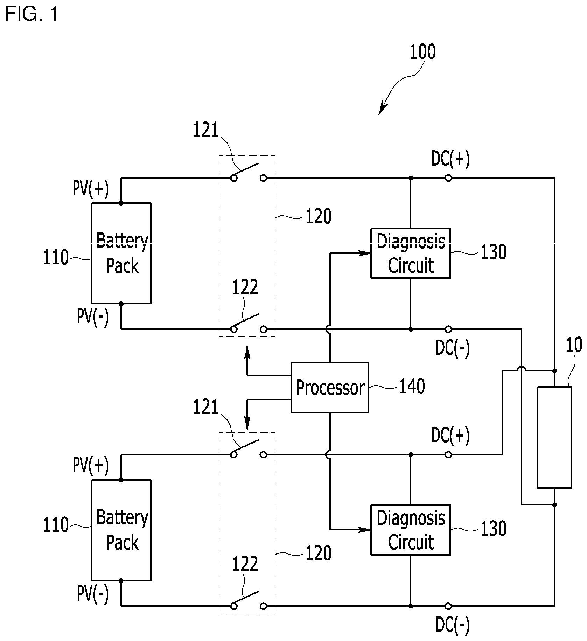

FIG. 1 is a diagram showing an example of a battery apparatus according to an embodiment.

Referring to FIG. 1, a battery apparatus 100 has a structure that can be electrically connected to an external apparatus 10 through a positive link terminal DC(+) and a negative link terminal DC(-). In some embodiments, the battery apparatus 100 may be connected to the external apparatus 10 through the positive link terminal DC(+) and the negative link terminal DC(-). When the external apparatus 10 is a load, the battery apparatus 100 may be discharged by operating as a power supply that supplies power to the load. When the external apparatus 10 is a charger, the battery apparatus 100 may be charged by receiving external power through the charger 10. In some embodiments, the external apparatus 10 operating as the load may be, for example, an electronic device, a mobility apparatus, or an energy storage system (ESS). The mobility apparatus may be, for example, a vehicle such as an electric vehicle, a hybrid vehicle, or a smart mobility.

The battery apparatus includes a plurality of battery packs 110, a plurality of switching circuits 120, a plurality of diagnosis circuits 130, and a processor 140.

The battery packs 110 are connected in parallel to the link terminals DC(+) and DC(-) through the switching circuits 120. The switching circuits 120 corresponds to the battery packs 110, respectively. That is, each of the switching circuits 120 is connected to a corresponding battery pack 110 among the battery packs 110. Each of the battery packs 110 includes a plurality of battery cells (not shown), and has a positive terminal PV(+) and a negative terminal PV(-). In some embodiments, the battery cell may be a rechargeable battery. In some embodiments, a predetermined number of battery cells may be connected in series in the battery pack 110 to form a battery module for supplying desired power. In some embodiments, a predetermined number of battery modules may be connected in series or in parallel in the battery pack 110 to supply the desired power.

Each of the switching circuits 120 includes a positive switch 121 and a negative switch 122. The positive switch 121 is connected between the positive terminal PV(+) of the corresponding battery pack 110 and the positive link terminal DC(+) of the battery apparatus. The negative switch 122 is connected between the negative terminal PV(-) of the corresponding battery pack 110 and the negative link terminal DC(-) of the battery apparatus. The switches 121 and 122 are controlled by the processor 140 to control electrical connection between the battery pack 110 and an external apparatus. In some embodiments, each of the switches 121 and 122 may include a contactor including a relay. In some embodiments, each of the switches 121 and 122 may include an electrical switch such as a transistor. In some embodiments, the switching circuit 120 may further include driving circuits (not shown) for driving the switches 121 and 122 respectively in response to control signals from the processor 140. When the positive switch 121 and the negative switch 122 are closed, power may be supplied from the battery pack 110 to the external apparatus or may be supplied from the external apparatus to the battery pack 110. Closing of the switch may be expressed as on of the switch, and opening of the switch may be expressed as off of the switch.

The diagnosis circuits 130 correspond to the switching circuits 120, respectively. That is, each of the diagnosis circuits 130 is connected between a corresponding switching circuit 120 among the switching circuits 120 and the link terminals DC(+) and DC(-). Each diagnosis circuit 130 includes a capacitor (not shown) which is charged by the power supplied from the corresponding battery pack 110 when the positive switch 121 and the negative switch 122 of the corresponding switching circuit 120 are normally closed.

The processor 140 controls the switching circuits 120 and the diagnosis circuits 130. When the switching circuit 120 operates normally, the corresponding diagnosis circuit 130 may be charged with a voltage of the corresponding battery pack 110. However, when the switching circuit 120 does not operate normally, the corresponding diagnosis circuit 130 may not be charged with the voltage of the corresponding battery pack 110. In some embodiments, if a difference between a voltage charged in the capacitor of a certain diagnosis circuit 130 and a voltage of a corresponding battery pack 110 is less than or equal to a predetermined voltage after a predetermined time has elapsed from a time at which the switching circuits 120 and the diagnosis circuits 130 are operated, the processor 140 may diagnose the switches 121 and 122 of a corresponding switching circuit 120 as normal. For example, if the voltage charged to the capacitor of the certain diagnosis circuit 130 has a voltage corresponding to the voltage of the corresponding battery pack 110, the processor 140 may diagnose the switches 121 and 122 of the corresponding switching circuit 120 as normal. Contrary, if the difference between a voltage charged in the capacitor of a certain diagnosis circuit 130 and a voltage of a corresponding battery pack 110 is greater than the predetermined voltage after the predetermined time has elapsed from the time at which the switching circuits 120 and the diagnosis circuits 130 are operated, the processor 140 may diagnose that at least one of the switches 121 and 122 of a corresponding switching circuit 120 is faulty. For example, if the voltage charged in the capacitor of the certain diagnosis circuit 130 does not have the voltage corresponding to the voltage of the corresponding battery pack 110, the processor 140 may diagnose that at least one of the switches 121 and 122 of the corresponding switching circuit 120 is faulty. For example, the processor 140 may diagnose that the switches 121 and 122 are stuck. In some embodiments, the voltage corresponding to the voltage of the battery pack 110 may be the same voltage as the voltage of the battery pack 110. In some embodiments, the voltage corresponding to the voltage of the battery pack 110 may be a voltage corresponding to a predetermined ratio of the voltage of the battery pack 110, and the predetermined ratio may be 100% or less.

In some embodiments, the capacitor of the diagnosis circuit 130 used for diagnosis of the switching circuit 120 may be a capacitor provided separately from a capacitor used for precharging (i.e., a capacitor used to prevent an inrush current when connecting to the external apparatus 10).

The processor 140 may connect the battery packs 110 to the link terminals DC(+) and DC(-) via the switching circuits 120 and the diagnosis circuits 130 after the diagnosis through the diagnosis circuits 130.

According to the above-described embodiments, even if the switching circuits 120 for the battery packs 110 are connected to the same link terminals DC(+) and DC(-), a fault in each of the switching circuits 120 may be diagnosed through the corresponding diagnosis circuit 130.

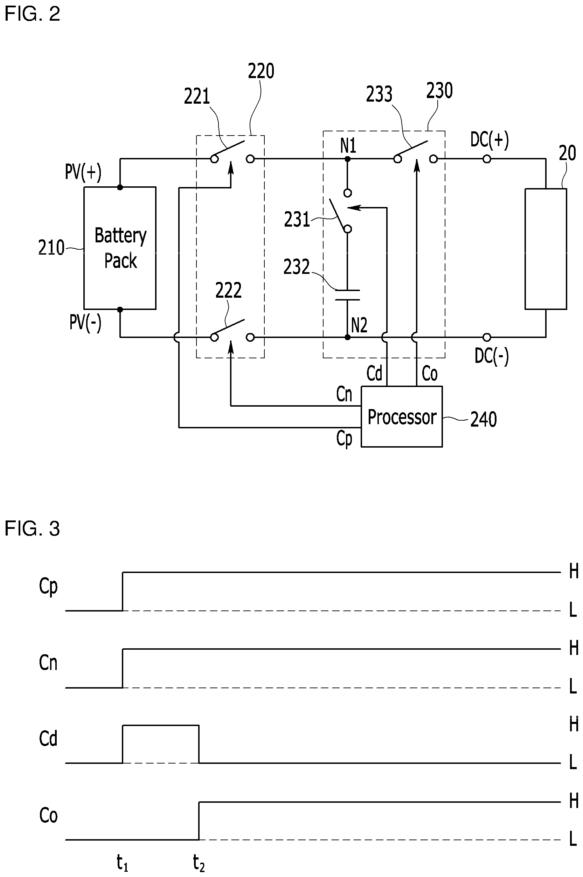

FIG. 2 is a drawing showing an example of a battery apparatus according to another embodiment, and FIG. 3 is a drawing showing an example of switching timings of a battery apparatus shown in FIG. 2.

Referring to FIG. 2, a battery apparatus includes a battery pack 210, a switching circuit 220, a diagnosis circuit 230, and a processor 240. Although FIG. 2 shows a circuit connected to one battery pack for convenience, a switching circuit and diagnosis circuit having the same structure may be connected to other battery packs as described with reference to FIG. 1.

The switching circuit 220 is connected among output terminals PV(+) and PV(-) of the battery pack 210 and nodes N1 and N2, and the diagnosis circuit 230 is connected between among the nodes N1 and N2 and link terminals DC(+) and DC(-).

A positive switch 221 of the switching circuit 220 is connected between the positive terminal PV(+) of the battery pack 210 and the node N1, and a negative switch 222 of the switching circuit 220 is connected between the negative terminal PV(-) of the battery pack 210 and the node N2.

The diagnosis circuit 230 includes a diagnosis switch 231, a diagnosis capacitor 232, and an operation switch 233. The diagnosis switch 231 and the diagnosis capacitor 232 are connected in series between the nodes N1 and N2. The operation switch 233 is connected between the node N1 and the positive link terminal DC(+), and the node N2 is connected to the negative link terminal DC(-).

Referring to FIG. 3, the processor 240 outputs control signal Cp and Cn having an enable level to drive the battery apparatus at a time t1. The positive switch 221 and the negative switch 222 are closed in response to the enable level of the control signals Cp and Cn, respectively. In some embodiments, the enable level may be, for example, a high level H. Further, the processor 240 transfer a control signal Cd having the enable level to the diagnosis switch 231 to diagnose the switching circuit 220 at time t1, and the diagnosis switch 231 is closed in response to the enable level of the control signal Cd. On the other hand, the processor 240 maintains a control signal Co transferred to the operation switch 233 at a disable level. In some embodiments, the disable level may be, for example, a low level L. Then, the switch 233 is open and the switches 221, 222, and 231 are closed so that the diagnosis capacitor 232 can be charged by the battery pack 210.

When a predetermined time has elapsed from the time t1, the processor 240 compares a voltage of the battery pack 210 with a voltage charged in the capacitor 232 to diagnose whether the switching circuit 220, for example, the switches 221 and 222 are faulty. In some embodiments, the predetermined time may be set to a time during which the capacitor 232 can be sufficiently charged.

In some embodiments, the battery apparatus may further include a voltage sensing circuit for measuring the voltage of the battery pack 210 and the voltage charged to the capacitor 232.

In some embodiments, the processor 240 may receive the voltage of the battery pack 210 and the voltage charged in the capacitor 232, and determine whether the voltage charged in the capacitor 232 is equal to or greater than a predetermined voltage. The processor 240 may diagnose the switches 221 and 222 as normal when the voltage charged in capacitor 232 is equal to or higher than a predetermined voltage, and may diagnose at least one of the switches 221 and 222 as a fault when the voltage charged in capacitor 232 is lower than the predetermined voltage. In some embodiments, the predetermined voltage may be equal to the voltage of the battery pack 210. In some embodiments, the predetermined voltage may be determined as a predetermined ratio of the voltage of the battery pack 210, and the predetermined ratio may be 100% or less. In some embodiments, the battery apparatus may further include an analog-to-digital converter that converts the voltage of the battery pack 210 and the voltage charged in the capacitor 232 into digital signals and transfer them to the processor 240.

In some embodiments, the battery apparatus may further include a comparator (not shown). The comparator may compare the voltage of the battery pack 210 with the voltage charged in the capacitor 232, and output a comparison result. The processor 240 may diagnose whether the switches 221 and 222 are faulty based on the comparison result of the comparator.

Next, the processor 240 switches the control signal Cd transferred to the diagnosis switch 231 to the disable level at a time t2, and the control signal Co transferred to the operation switch 233 to the enable level. Accordingly, the diagnosis switch 231 is opened and the operation switch 233 is closed, so that the power of the battery pack 210 can be transferred to an external apparatus 20 through the link terminals DC(+) and DC(-).

Although FIG. 3 shows that the control signals Cp, Cn, and Cd are simultaneously switched to the enable level at the time t1, there may be a difference in the switching times of the levels of the control signals Cp, Cn, and Cd. For example, after the control signal Cn is first switched to the enable level, the control signals Cp and Cd may be switched to the enable level. Likewise, although FIG. 3 shows that the levels of the control signals Cd and Co are simultaneously switched at the time t2, there may be a difference in the switching times of the levels of the control signals Cd and Co. For example, after the control signal Co is first switched to the enable level, the control signal Cd may be switched to the disable level.

According to the above-described embodiments, the processor 240 can use the diagnosis circuit 230 corresponding to each battery pack 210 to diagnose whether the switches 221 and 222 of the corresponding switching circuit 220 are faulty. Thus, a plurality of switching circuits 220 connected in common to the link terminals DC(+) and DC(-) can be individually diagnosed.

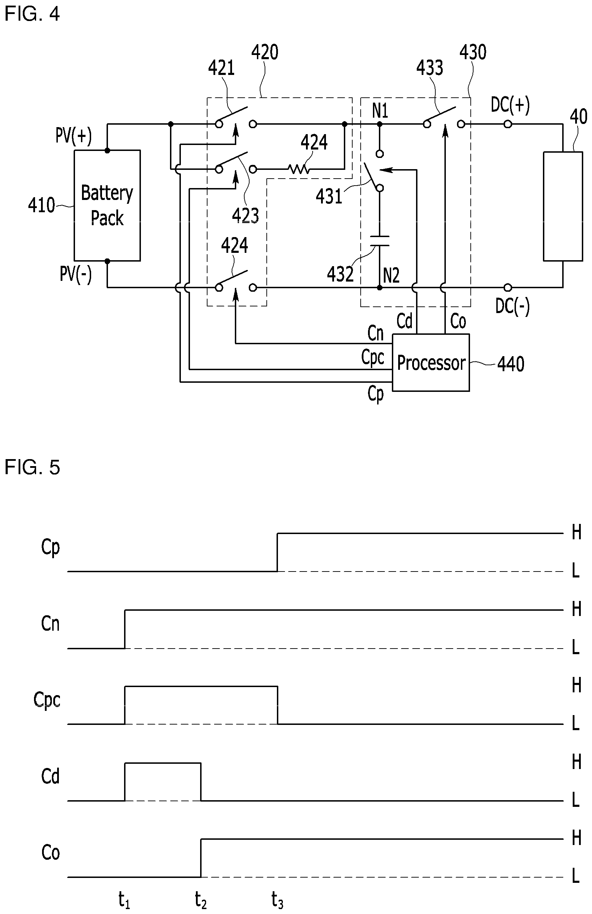

FIG. 4 is a drawing showing an example of a battery apparatus according to yet another embodiment, and FIG. 5 is a drawing showing an example of switching timings of a battery apparatus shown in FIG. 4.

Referring to FIG. 4, a battery apparatus includes a battery pack 410, a switching circuit 420, a diagnosis circuit 430, and a processor 440. Although FIG. 4 shows a circuit connected to one battery pack for convenience, a switching circuit and diagnosis circuit having the same structure may be connected to other battery packs as described with reference to FIG. 1.

The switching circuit 420 is connected among output terminals PV(+) and PV(-) of the battery pack 410 and nodes N1 and N2, and the diagnosis circuit 430 is connected among the nodes N1and N2 and link terminals DC(+) and DC(-). The switching circuit 420 includes a positive switch 421, a negative switch 422, and a precharge circuit. In some embodiments, the precharge circuit may include a precharge switch 423 and a precharge resistor 424.

The positive switch 421 of the switching circuit 420 is connected between the positive terminal PV(+) of the battery pack 410 and the node N1, and the negative switch 422 of the switching circuit 420 is connected to the negative terminal PV(-) of the battery pack 410 and the node N2. The precharge switch 423 and the precharge resistor 424 may be connected in series between the positive terminal PV(+) of the battery pack 110 and the node N1. In some embodiments, the positive switch 421 and the precharge circuit 423 and 424 may be connected in parallel between the positive terminal PV(+) of the battery pack 410 and the node N1.

The diagnosis circuit 430 includes a diagnosis switch 431, a diagnosis capacitor 432, and an operation switch 433. The diagnosis switch 431 and the diagnosis capacitor 432 are connected in series between the nodes N1 and N2. The operation switch 433 is connected between the node N1 and the positive link terminal DC(+), and the node N2 is connected to the negative link terminal DC(-).

Referring to FIG. 5, the processor 440 outputs control signals Cpc and Cn having an enable level to drive the battery apparatus at a time t1. The precharge switch 423 and the negative switch 422 are closed in response to the enable levels of the control signals Cpc and Cn, respectively. In some embodiments, the enable level may be, for example, a high level H. In addition, the processor 440 transfers a control signal Cd having an enable level to the diagnosis switch 431 for diagnosis of the switching circuit 420 at the time t1, and the diagnosis switch 431 is closed in response to the enable level of the control signal Cd. The processor 440 maintains the control signal Co transferred to the operation switch 433 at a disabled level. In some embodiments, the disable level may be, for example, a low level L. Then, when the switch 433 is open and the switches 422, 423, and 431 are closed, the diagnosis capacitor 432 can be charged by battery pack 410.

When a predetermined time has elapsed from the time t1, the processor 440 compares a voltage of the battery pack 410 with a voltage charged in the capacitor 432 to diagnose whether the switching circuit 220, for example, the switches 221 and 222 are faulty.

Next, the processor 440 switches the control signal Cd transferred to the diagnosis switch 431 to the disable level at a time t2, and the control signal Co transferred to the operation switch 433 to the enable level. Accordingly, the diagnosis switch 431 is opened and the operation switch 433 is closed, so that a capacitor of an external apparatus 40 can be precharged by the battery pack 410.

Next, after the precharge of the capacitor of the external apparatus 40 is completed, the processor 440 switches the control signal Cp transferred to the positive switch 421 to the enable level at a time t3, and the control signal Cpc transferred to the precharge switch 423 to the disabled level. Accordingly, the power of the battery pack 210 can be transferred to the external apparatus 40 through the link terminals DC(+) and DC(-).

While it has been described in FIG. 5 that the precharge switch 423 is closed at the time t1, it is also possible to diagnose whether the switches 421 and 422 are faulty by closing the positive switch 421 as described with reference to FIG. 3.

Although FIG. 5 shows that the control signals Cpc, Cn, and Cd are simultaneously switched to the enable level at the time t1, there may be a difference in the switching times of the levels of the control signals Cpc, Cn, and Cd. For example, after the control signal Cn is first switched to the enable level, the control signals Cpc and Cd may be switched to the enable level. Further, although FIG. 5 shows that the levels of the control signals Cd and Co are simultaneously switched at the time t2, there may be a difference in the switching times of the levels of the control signals Cd and Co. For example, after the control signal Co is first switched to the enable level, the control signal Cd may be switched to the disable level. Likewise, although FIG. 5 shows that the levels of the control signals Cpc and Cp are simultaneously switched at the time t3, there may be a difference at the switching times of the levels of the control signals Cpc and Cp. For example, after the control signal Cp is first switched to the enable level, the control signal Cpc may be switched to the disable level.

According to the above-described embodiments, the processor 440 can use the diagnosis circuit 430 corresponding to each battery pack 410 to diagnose whether the switches 421, 422, and 423 of the corresponding switching circuit 420 including the precharge are faulty.

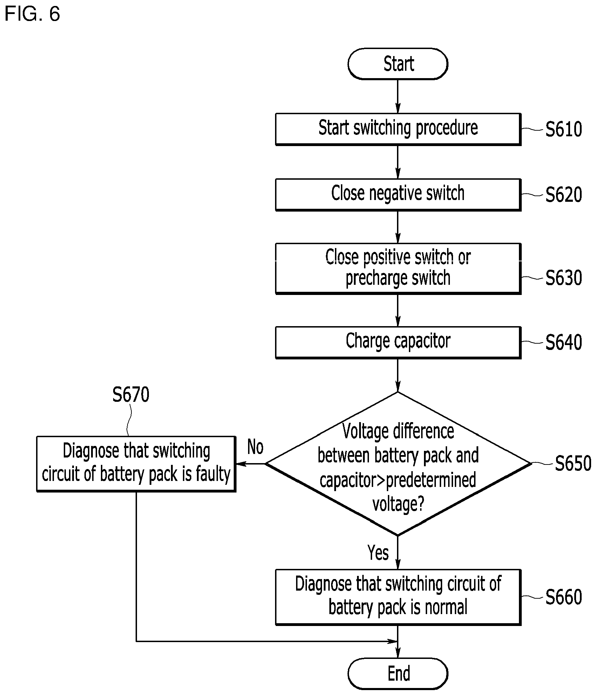

FIG. 6 is a flowchart showing an example of a diagnosis method according to an embodiment.

Referring to FIG. 6, a battery management system of a battery apparatus starts a switching procedure to supply power through battery packs at S610. First, a negative switch (e.g., 222 in FIG. 2 or 422 in FIG. 4) of the battery packs is closed at S620. In some embodiments, the battery management system may transfer a control signal having an enable level to the negative switch 222 or 422 to close the negative switch 222 or 422 at S620.

Further, the battery management system closes a positive switch (e.g., 221 in FIG. 2) or a precharge switch (e.g., 423 in FIG. 4) of the battery packs at S630, and charges a capacitor that is individually provided each of the battery packs through a corresponding battery pack at S640. In some embodiments, the battery management system may transfer a control signal having the enable level to the positive switch 221 or the precharge switch 423 to close the positive switch 221 or the precharge switch 423 at S630.

Next, the battery management system diagnoses a switching circuit of each battery pack based on a voltage of each battery pack and a voltage of the corresponding capacitor at S650, S660, and S670. In some embodiments, the battery management system may compare the voltage of each battery pack with the voltage of the corresponding capacitor at S650. When a difference between the voltage of a certain battery pack and the voltage of the corresponding capacitor is less than or equal to a predetermined voltage at S650, the battery management system may diagnose that the switching circuit of the certain battery pack is normal at S660. When the difference between the voltage of a certain battery pack and the voltage of the corresponding capacitor is greater than the predetermined voltage at S650, the battery management system may diagnose that the switching circuit of the certain battery pack is faulty at S670.

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims.

## Claims

1. A battery apparatus connected to an external apparatus through a first link terminal and a second link terminal, the battery apparatus comprising:
a first battery pack and a second battery pack connected in parallel;
a first switching circuit comprising a first switch connected between a first terminal of the first battery pack and the first link terminal, and a second switch connected between a second terminal of the first battery pack and the second link terminal;
a second switching circuit comprising a third switch connected between a first terminal of the second battery pack and the first link terminal, and a fourth switch connected between a second terminal of the second battery pack and the second link terminal;
a first diagnosis circuit comprising a first capacitor configured to charge a voltage of the first battery pack when the first switch and the second switch are closed;
a second diagnosis circuit comprising a second capacitor configured to charge a voltage of the second battery pack when the third switch and the fourth switch are closed; and
a processor configured to diagnose the first switching circuit based on the voltage of the first battery pack and a voltage of the first capacitor, and diagnose the second switching circuit based on the voltage of the second battery pack and a voltage of the second capacitor.

2. The battery apparatus of claim 1, wherein the processor is configured to diagnose that the first switching circuit is normal when a difference between the voltage of the first battery pack and the voltage of the first capacitor is less than or equal to a predetermined voltage.

3. The battery apparatus of claim 1, wherein the processor is configured to diagnose that the first switching circuit is faulty when a difference between the voltage of the first battery pack and the voltage of the first capacitor is greater than a predetermined voltage.

4. The battery apparatus of claim 1, wherein the processor is configured to diagnose that the first switching circuit is normal when a voltage of the first capacitor is greater than a predetermined ratio of the voltage of the first battery pack.

5. The battery apparatus of claim 1, wherein the processor is configured to diagnose that the first switching circuit is faulty when a voltage of the first capacitor is less than or equal to a predetermined ratio of the voltage of the first battery pack.

6. The battery apparatus of claim 1, wherein the first diagnosis circuit further comprises a fifth switch and a sixth switch,
wherein the first switch is connected between the first terminal of the first battery pack and a node,
wherein the fifth switch and the first capacitor are connected in series between the node and the second link terminal, and
wherein the sixth switch is connected between the node and the first link terminal.

7. The battery apparatus of claim 6, wherein the processor is configured to
open the sixth switch and close the first switch, the second switch, and the fifth switch to charge the first capacitor, and
close the sixth switch and open the fifth switch to supply the voltage of the first battery pack to the first link terminal.

8. The battery apparatus of claim 1, wherein the first capacitor and the second capacitor are provided separately from a capacitor used for precharge.

9. A battery management system of a battery apparatus having a first link terminal and a second link terminal connected to an external apparatus, the battery management system comprising:
a switching circuit comprising a first switch connected between a first terminal of a battery pack of the battery apparatus and a node, and a second switch connected between a second terminal of the battery pack and the second link terminal;
a third switch and a capacitor connected in series between the node and the second link terminal;
a fourth switch connected between the node and the first link terminal; and
a processor configured to control the first switch, the second switch, the third switch, and the fourth switch.

10. The battery management system of claim 9, wherein the processor is configured to diagnose the switching circuit based on a voltage of the battery pack and a voltage of the capacitor.

11. The battery management system of claim 10, wherein for diagnosis of the switching circuit, the processor is configured to open the fourth switch and close the first switch, the second switch, and the third switch to charge the capacitor.

12. The battery management system of claim 11, wherein the processor is configured to close the fourth switch and open the third switch to supply the voltage of the battery pack to the external apparatus after diagnosing the switching circuit.

13. The battery management system of claim 10, wherein the processor is configured to diagnose that the switching circuit is normal when a difference between the voltage of the battery pack and the voltage of the capacitor is less than or equal to a predetermined voltage.

14. The battery management system of claim 10, wherein the processor is configured to diagnose that the switching circuit is faulty when a difference between the voltage of the battery pack and the voltage of the capacitor is greater than a predetermined voltage.

15. A diagnosis method of a battery apparatus including a plurality of battery packs connected in parallel, the diagnosis method comprising:
charging a plurality of capacitors respectively provided in the plurality of battery packs;
comparing a voltage of each of the plurality of battery packs with a voltage of a corresponding capacitor among a plurality of capacitors;
when a difference between a voltage of a first battery pack among the plurality of battery packs and a voltage of a capacitor corresponding to the first battery pack among the plurality of capacitors is less than or equal to a predetermined voltage, diagnosing that a switching circuit connected to the first battery pack is normal; and
when a difference between a voltage of a second battery pack among the plurality of battery packs and a voltage of a capacitor corresponding to the second battery pack among the plurality of capacitors is greater than the predetermined voltage, diagnosing that a switching circuit connected to the second battery pack is faulty.
